**Europäisches Patentamt**

**European Patent Office**

**Office européen des brevets**

(19)

(11) Numéro de publication: **0 194 193 B1**

(12) # FASCICULE DE BREVET EUROPEEN

(45) Date de publication du fascicule du brevet:
14.06.89

(51) Int. Cl.⁴: **H01L 21/28,** H01L 29/62, H01L 29/78

(21) Numéro de dépôt: 86400381.9

(22) Date de dépôt: 21.02.86

(54) Procédé de fabrication d'un circuit intégré à transistors MOS à électrodes en siliciure métallique.

(30) Priorité: 26.02.85 FR 8502768

(43) Date de publication de la demande:
10.09.86 Bulletin 86/37

(45) Mention de la délivrance du brevet:
14.06.89 Bulletin 89/24

(84) Etats contractants désignés:
AT DE FR GB IT NL

(56) Documents cités:
EP-A- 0 101 000
EP-A- 0 124 954
US-A- 4 384 301

IBM TECHNICAL DISCLOSURE BULLETIN,
vol. 25, no. 3B, août 1982, pages 1396-1397, New York,
US; H.J. GEIPEL, Jr. et al.: "Process for simultaneously
making silicide gate, source and drain electrodes"
IEEE TRANSACTIONS ON ELECTRON DEVICES, vol.
ED-31, no. 9, septembre 1984, pages 1329-1334, IEEE,
New York, US; H. OKABAYASHI et al.: "Low-resistance
MOS technology using self-aligned refractory
silicidation"

(73) Titulaire: SGS-THOMSON MICROELECTRONICS S.A., 7,
Avenue Galliéni, F-94250 Gentilly(FR)

(72) Inventeur: Roche, Alain, THOMSON-CSF
SCPI 19, Avenue de Messine, F-75008 Paris(FR)
Inventeur: Borel, Joseph, THOMSON-CSF
SCPI 19, Avenue de Messine, F-75008 Paris(FR)

(74) Mandataire: Rinuy, Santarelli et al, 14, avenue de la
Grande Armée, F-75017 Paris(FR)

ACTORUM AG

## Description

La présente invention concerne un procédé de fabrication decircuits intégrés à transistors MOS à haute densité d'intégration.

On cherche à faire des circuits de plus en plus petits et incorporant le plus grand nombre possible d'éléments. Ceci implique que l'on réalise des structures d'éléments individuels aussi petits que possible et que l'on utilise des technologies d'intégration avec autoalignement des motifs formés successivement sur les pastilles de circuit.

En particulier, une technique maintenant très utilisée consiste à utiliser des grilles de transistors MOS en silicium polycritallin dopé, gravées avant l'implantation des régions de source et de drain des transistors : la grille sert de masque lors de l'implantation ; la source et le drain sont donc autoalignées par rapport aux bords de la grille.

On se sert aussi de couches de silicium polycristallin pour réaliser des électrodes de source et de drain en contact avec le silicium monocristallin du substrat et pour réaliser des interconnexions entre transistors. Outre l'aptitude du silicium polycristallin dopé (du même type de conductivité que la source et le drain) à servir de masque lors de l'implantation des régions de source et de drain, ce matériau présente l'avantage de réaliser un bon contact ohmique avec les régions de source et de drain.

Malheureusement, même si le silicium polycristallin est fortement dopé, sa conductivité est relativement limitée et on éprouve le besoin de l'augmenter (puisqu'il sert à réaliser des connexions conductrices entre éléments) ; pour cela on forme une couche de siliciure métallique (siliciure de platine, titane, tantale par exemple) à la surface supérieure du silicium polycristallin.

Cette couche est formée en déposant au-dessus du silicium polycristallin une couche métallique (par pulvérisation cathodique à partir d'une cible du métal considéré) et en formant par recuit un alliage (siliciure) avec le silicium polycristallin situé au-dessous. On peut aussi déposer directement un siliciure par pulvérisation cathodique d'une cible de siliciure métallique fritté. Ceci dépend du métal considéré.

La présente invention propose un procédé de fabrication d'un circuit intégré comportant des transistors dont la grille ne comporte pas de silicium polycristallin et qui évite donc des étapes longues et délicates dans le procédé de fabrication (notamment le dépôt du silicium polycristallin, son dopage et sa désoxydation après dopage).

Un circuit intégré comportant des transistors MOS formés dans un substrat de silicium monocristallin, les transistors ayant chacun une région de source, une région de drain et une région de canal séparant la région de source de la région de drain, ainsi qu'une électrode de source, une électrode de drain, et une électrode de grille isolée de la région de canal par une couche mince isolante, le circuit étant tel que l'électrode de grille est constituée par une portion de couche de siliciure métallique directement en contact avec la couche isolante mince, et les électrodes de source et de drain étant constituées respectivement par d'autres portions de couche de siliciure métallique, ces autres portions étant en contact direct avec le silicium monocristallin des régions de source et de drain respectivement est, par exemple, connu de l'article de J. GEIPEL et S. ROBERTS dans "IBM Technical Disclosure Bulletin" vol. 25, n° 3B, Août 1982, pages 1396–1397. Cet article décrit son procédé de fabrication qui comporte une étape dans laquelle une couche de siliciure de métal, tel que le tantale, est déposée uniformément sur un masque de photodésist pourvu de fenêtres à l'implacement des régions de source, drain et grille. Ce masque est ensuite éliminé et des extensions des régions source et drain réalisées par implantation d'ions dopants de telle sorte que la grille serve de masque et soit donc auto-alignée. Une couche de SiO₂ est déposée sur le siliciure restant préalablement à l'implantation.

Le procédé de fabrication selon l'invention, évite, quant à lui, l'opération de "lift-off"' du procédé connu et permet un dépôt du siliciure de metal sans ruptures, la grille étant délimitée par gravure du siliciure. Je comprend les étapes successives suivantes :

a) formation sur un substrat de silicium monocristallin d'un premier type de conductivité, dans une zone active, d'une couche mince isolante constituant l'isolant de grille d'un transistor à effet de champ ;

b) gravure de la couche isolante pour dénuder le silicium monocristallin dans des zones de contact entre des régions de source et drain et des électrodes de source et drain ;

c) dépôt uniforme d'un siliciure métallique sur la totalité du substrat, le siliciure reposant sur l'isolant de grille là où il est présent et venant en contact direct avec le silicium monocristallin sur le reste de la zone active,

d) dépôt d'une couche photosensible apte à résister à des produits de gravure du siliciure et apte à servir de masque arrêtant les impuretés lors d'une opération d'implantation d'impuretés

e) photogravure de la couche photosensible pour réaliser un motif de résine comprenant une portion de résine au-dessus de l'isolant de grille, cette portion correspondant au motif de la grille à réaliser, et des portions de résine définissant une électrode de source, une électrode de drain et des interconnexions, la résine étant éliminée le long des bords de la grille au-dessus de la zone active et subsistant au-dessus du siliciure dans des portions de zone active où le siliciure est en contact avec le silicium monocristallin ;

f) gravure du siliciure là où il n'est pas protégé par la résine,

g) implantation ionique d'impuretés pour définir des régions de source et de drain,

h) élimination de la résine,

i) recuit du substrat.

Pour compléter le dopage des régions de source et de drain là où le siliciure est en contact avec le silicium monocristallin, on peut soit effectuer une implantation (avec masquage du canal par une résine) avant l'opération b soit effectuer une implantation (également masquée par une résine) à travers le siliciure après l'opération h.

On obtient ainsi un procédé de fabrication plus simples que ceux qui utilisent du silicium polycristallin.

On comprendra dans la suite que lorsqu'on parle de résine photosensible, il s'agit notamment de résines dites multicouches consistant dans la superposition de plusieurs couches de matériaux différents dont seule une couche supérieure est véritablement une résine photosensible.

D'autres caractéristiques et avantages de l'invention apparaîtront à la lecture de la description détaillée qui suit et qui est faite en référence aux dessins annexés dans lesquels :

- la figure 1 représente la structure d'un transistor MOS d'un circuit fabriqué par le procédé selon l'invention,
- les figures 2 à 8 représentent des étapes successives de fabrication pour aboutir à la structure de la figure 1.

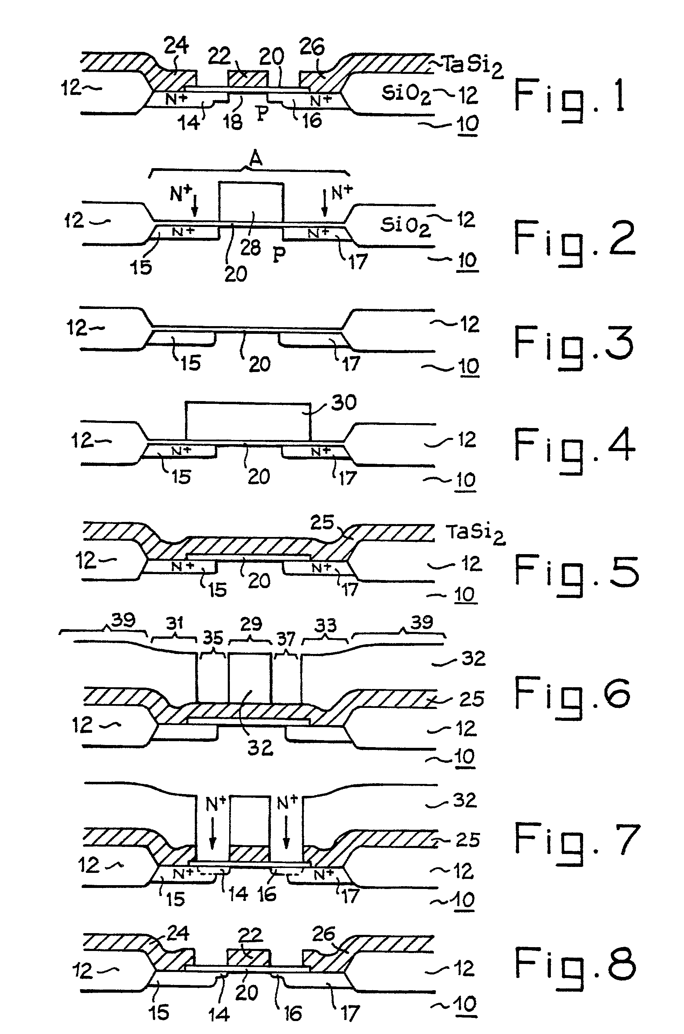

La figure 1 représente en coupe transversale un transistor MOS formé dans un substrat de silicium monocristallin 10. Il pourrait aussi être formé dans un caisson de type de conductivité opposé à celui du substrat (notamment pour des circuit intégrés de technologie CMOS). Ici le substrat est de type P par exemple.

Le transistor est formé dans une zone active entourée par un mur d'oxyde de silicium épais 12. On peut prévoir comme cela est classique que le substrat de type P est plus fortement dopé sous l'oxyde épais que dans la zone active. L'épaisseur d'oxyde est par exemple de 500 nm.

Une région de source 14 fortement dopée avec une impureté de type de conductivité opposé au substrat et une région de drain 16 dopée comme la région de source sont formées à la surface du substrat et sont séparées par une région de canal 18 de type P constituée par le substrat lui-même.

La région de canal 18 est recouverte d'une couche isolante mince 20, en principe d'oxyde de silicium ($SiO_2$). L'épaisseur est de quelques dizaines de nm ou moins.

Au-dessus de la région de canal est formée une grille conductrice 22 qui repose sur la couche isolante mince 20.

La grille est autoalignée par rapport à la région de canal, c'est-à-dire que ses bords surplombent les bords de la région de canal en débordant très peu au-dessus des bords des régions de source et de drain adjacentes à la région de canal.

Une électrode de source 24 vient en contact avec une partie de la surface du silicium monocristallin de la région de source 14 et remonte éventuellement sur l'oxyde épais 12. Cette électrode 24 est séparée de la grille de sorte qu'il reste une portion de région de source non recouverte de siliciure.

De même une électrode de drain 26 vient en contact avec au moins une partie de la surface du silicium monocristallin de la région de drain et remonte éventuellement sur l'oxyde épais 12. Cette électrode 26 est également séparée de la grille de sorte qu'il subsiste une portion de région de drain non recouverte de siliciure.

La grille conductrice 22 et les électrodes de source et de drain sont formées par des portions séparées d'une même couche d'un siliciure métallique, qui est directement en contact avec le silicium monocristallin dans les régions de source et de drain, et qui est directement en contact avec l'isolant de grille 20 au-dessus du canal.

Le siliciure choisi de préférence est du siliciure de tantale $TaSi_2$.

La couche de siliciure sert également à former des interconnexions notamment au-dessus des murs d'oxyde épais.

Sur la figure 1, les régions de source et de drain s'étendent sans discontinuité entre la région de canal et le mur d'oxyde épais 12 entourant la zone active.

Sur la figure 1 on n'a pas représenté les couches d'isolation et de passivation, ainsi d'ailleurs que d'autres couches d'interconnexions qui peuvent être prévues sur plusieurs niveaux dans un circuit intégré.

Les étapes de fabrication de cette structure sont représentées aux figures suivantes. On ne décrira que les étapes essentielles correspondant à la formation des électrodes de grille, de source et de drain, d'autres étapes classiques pouvant être exécutées avant ou après les étapes représentées (par exemple des implantations de couches anti-inversion, des implantations d'enrichissement ou de déplétion etc...).

La figure 2 représente le substrat 10, par exemple de type P, résistivité environ 20 ohms-cm, sur lequel on a formé un mur épais d'oxyde de silicium 12 entourant une zone active A.

On forme dans cette zone active A une couche isolante mince 20, par exemple une couche d'oxyde de silicium obtenue par oxydation thermique. L'épaisseur peut être de quelques dizaines de nm ou moins, par exemple 20 nm.

Puis un dépôt de résine photosensible 28 est effectué et est photogravé avec un masque définissant un premier motif tel que la résine subsiste au-dessus d'une zone légèrement plus large que la future grille du transistor. L'excès de largeur est choisi tel que ce premier motif recouvre de manière certaine (compte tenu des tolérances de positionnement des masques successifs) le futur motif de grille.

La résine est une résine apte à servir de masque protégeant le silicium pendant l'implantation d'impuretés qui suit.

On procède alors à une implantation ionique d'impuretés (phosphore) de dopage des régions de source et de drain de part et d'autre de la résine 28. Il est à noter que cette opération de dépôt d'une résine et d'implantation pourrait aussi être faite en fin de processus.

On forme ainsi une portion de région de source 15 et une portion de région de drain 17 qui devront être complétées vers la grille pour réaliser les régions 14 et 16 autoalignées de la figure 1.

Après cela on élimine la résine 28 (Fig. 3). On dépose une nouvelle couche de résine 30 que l'on grave selon un deuxième motif tel que la résine 30 subsiste au-dessus d'une zone plus large que celle qui correspond au premier motif. Plus précisément la résine est surtout éliminée dans la zone active A à proximité des murs épais 12, de manière à dénuder la couche isolante mince 20 au-dessus d'une partie de la région 15 et au-dessus d'une partie de la région 17. Ces zones dénudées définiront les contacts de source et de drain. Ces zones doivent être de dimension suffisante pour établir un bon contact électrique mais elles doivent être assez éloignées du futur canal comme on le verra en fonction de la suite du procédé.

On élimine alors l'oxyde mince 20 là où il n'est pas protégé par la résine. Puis on enlève la résine. On notera que la résine 30 peut être déposée en couche beaucoup plus mince que la résine 28 car elle ne sert pas (en principe) de masque d'implantation mais seulement de protection pendant la gravure de l'oxyde mince 20.

On dépose ensuite uniformément une couche de siliciure métallique, de préférence du siliciure de tantale TaSi$_2$ sur l'ensemble de la surface du substrat. Le dépôt est fait par pulvérisation cathodique à partir d'une cible en siliciure de tantale fritté. La couche de siliciure 25 qui en résulte peut avoir une épaisseur de quelques centaines de nm, par exemple 200 nm (Figure 5).

Dans la zone active A, la couche de siliciure repose directement sur le silicium monocristallin, et sur la couche isolante mince 20 là où elle est présente c'est-à-dire sur une bande traversant toute la zone active A.

On dépose alors uniformément une couche de résine photosensible 32. Cette résine peut être notamment une structure en 3 couches que l'on utilise classiquement aujourd'hui. Elle a la propriété (une fois développée) de résister aux composés de gravure du siliciure métallique ; elle a aussi la propriété (une fois développée) d'absorber sans les laisser passer les impuretés d'implantation ionique (phosphore notamment) utilisées pour former les régions de source et de drain.

Par exemple la résine 32 consiste dans la superposition de 3 couches :
- une résine de base épaisse (2 microns environ), recuite à 200°C (résine novolak),
- une couche mince minérale (oxyde de titane ou de silicium d'une épaisseur de 100 nm).
- une résine photosensible proprement dite en couche mince résine novolak de 500 nm par exemple.

La résine tricouche ainsi déposée est photogravée pour définir un motif de zones protégeant le siliciure métallique, le siliciure étant mis à nu en dehors du motif après développement de la résine (Figure 6). La photogravure se fait selon le procédé suivant :
- insolation à travers un masque,
- développement photographique de la résine en couche mince,
- gravure ionique réactive de la couche minérale mince (plasma de CHF 3),
- gravure ionique réactive de la résine épaisse (plasma d'oxygène).

Le motif de siliciure protégé par la résine comprend :
- les grilles des transistors MOS,
- les électrodes de source,
- les électrodes de drain,
- des interconnexions entre éléments de circuit intégré.

Bien entendu on peut imaginer que certains transistors ne comportent pas d'électrodes de drain ou de source si par exemple les sources de plusieurs transistors sont constituées par une ligne unique de source diffusée. On ne considèrera ici que le cas général où à la fois une électrode de source et une électrode de drain sont présentes.

Plus précisément,le motif de résine 32 développé comprend plusieurs parties :
- le motif de résine 29 correspondant à la protection de l'électrode de grille est formé exclusivement au-dessus de la couche isolante mince 20,
- le motif de résine 31, 33 correspondant à la protection de l'électrode de source (ou de drain) recouvre les parties de siliciure métallique en contact avec le silicium monocristallin de la zone active et il est complètement séparé du motif 29 (correspondant à la grille) par un intervalle (35 côté source, 37 côté drain). Dans cet intervalle qui longe le motif de grille 29 de chaque côté de celui-ci, le siliciure est mis à nu,
- le motif de résine 39 correspondant aux interconnexions s'étend au-dessus de zones d'oxyde épais et il peut rejoindre les autres motifs selon la configuration d'interconnexions à réaliser.

On procède alors à la gravure du siliciure de tantale qui est éliminé là où il n'est pas protégé par la résine 32 (gravure anisotrope verticale, par exemple gravure par plasma d'un composé fluoré SF6 ou chloré). La gravure est arrêtée lorsque la couche isolante mince 20 est mise à nu.

On notera que la largeur des intervalles 35 et 37 dépourvus de résine est choisie aussi faible que possible. En revenant en arrière, on remarque qu'il a fallu choisir la largeur du deuxième motif de résine 30 suffisante pour englober la région 29, les régions 35 et 37 avec en outre une légère marge supplémentaire permettant de s'assurer, compte tenu des tolérances de positionnement de masques successifs, que les intervalles 35 et 37 sont à coup sûr situés au-dessus de l'oxyde mince.

On procède alors à une implantation ionique d'impuretés (phosphore) de dopage des extrémités (côté grille) des régions de source et de drain, la résine 32 restant en place (Figure 7).

On forme ainsi les extrémités autoalignées 14 et 16 des régions de source et drain de part et d'autre de la grille ; Il y a autoalignement en ce sens que c'est le même masque de photogravure qui délimite à la fois le bord des grilles (gravure du siliciure) et le bord de la région de source et de drain (implantation).

Il peut y avoir classiquement un léger débordement latéral de la région de source et de la région de drain sous la grille . Ce débordement latéral se produit notamment lors des opérations à haute température qui suivent l'étape d'implantation, et notamment lors du recuit qui est classiquement effectué ultérieurement, après retrait de la résine, pour rétablir la structure monocristalline qui a pu être endommagée par l'implantation.

Si à cette étape on retire la résine 32 (Figure 8), on aboutit à la même structure qu'à la figure 1, dans laquelle une électrode de source 24 contacte la région de source et de même une électrode de drain 26 contacte la région de drain. La grille est désignée par 22.

Dans une variante de réalisation, on n'exécute pas au début le masquage et l'implantation expliquées en référence à la figure 2. Mais on le fait à la fin du procédé, après avoir éliminé la résine 32 ; dans ce cas, l'implantation des régions 15 et 17 se fait à plus forte énergie à travers le siliciure des électrodes de source et de drain (la grille étant protégée par un motif de résine 28 identique à celui de la figure 2).

L'invention est applicable également en technologie CMOS, le siliciure du côté des transistors à canal N n'étant pas gravé en même temps que le siliciure du côté des transistors à canal P, mais deux gravures étant effectuées, chaque gravure étant suivie d'une implantation de source et de drain.

**Revendications**

1. Procédé de fabrication d'un circuit intégré, comprenant les étapes successives suivantes :

a) formation sur un substrat de silicium monocristallin (10) d'un premier type de conductivité, dans une zone active (A), d'une couche mince isolante (20) constituant l'isolant de grille d'un transistor à effet de champ ;

b) gravure de la couche isolante (20) pour dénuder le silicium monocristallin dans des zones de contact entre les régions de source et de drain et des électrodes correspondantes ;

c) dépôt uniforme d'un siliciure métallique (25) sur la totalité du substrat, le siliciure reposant sur l'isolant de grille là où il est présent et venant en contact direct avec le silicium monocristallin sur le reste de la zone active,

d) dépôt d'une couche photosensible (32) apte à résister à des produits de gravure du siliciure et apte à servir de masque arrêtant les impuretés lors d'une opération d'implantation d'impuretés

e) photogravure de la couche photosensible pour réaliser un motif de résine comprenant une portion de résine (29) au-dessus de l'isolant de grille, cette portion correspondant au motif de la grille à réaliser, et des portions de résine (31, 33, 39) définissant une électrode de source, une électrode de drain et des interconnexions, la résine étant éliminée le long des bords de la grille au-dessus de la zone active et subsistant au-dessus du siliciure dans des portions de zone active où le siliciure est en contact avec le silicium monocristallin ;

f) gravure du siliciure là où il n'est pas protégé par la résine,

g) implantation ionique d'impuretés pour définir des régions de source (14) et de drain (16),

h) élimination de la résine,

i) recuit du substrat.

2. Procédé selon la revendication 1, caractérisé en ce que, avant l'étape b), on dépose une couche de résine photosensible (28) que l'on grave pour la laisser subsister dans une zone recouvrant totalement le motif de grille en débordant légèrement de part et d'autre de celui-ci, et on effectue une implantation ionique d'impuretés de type opposé à celui du substrat.

3. Procédé selon la revendication 2, caractérisé en ce , après l'opération h), on dépose une couche de résine photosensible (28) que l'on grave pour la laisser subsister dans une zone recouvrant totalement le motif de grille en débordant légèrement de part et d'autre de celui-ci, et on effectue une implantation ionique d'impuretés de type opposé à celui du substrat, avec une énergie suffisante pour traverser le siliciure.

**Claims**

1. A method of producing an integrated circuit comprising the following successive stages:

a) formation of a thin insulating layer (20), constituting the gate insulator of a field effect transistor, in an active zone (A) on a substrate of monocrystalline silicon (10) having a first kind of conductivity;

b) etching of the insulating layer (20) to bare the monocrystalline silicon in the contact zones between the source and drain regions and the corresponding electrodes;

c) uniform deposition of a metal silicide (25) over all the substrate, the silicide resting on the gate insulator where it is present and coming into direct contact with the monocrystalline silicon over the remainder of the active zone;

d) deposition of a photosentive layer (32) suitable to resist the materials for etching the silicide and suitable to serve as a mask holding back the impurities during an operation of implanting impurities;

e) photoetching of the photosensitive layer to produce a resin pattern comprising a portion of resin (29) above the gate insulator, this portion corresponding to the pattern of the gate to be made, and portions of resin (31, 33, 39) defining a source electrode, a drain electrode and interconnections, the resin being removed along the edges of the gate above the active zone and remaining above the silicide in the portions of the active zone where the silicide is in contact with the monccrystalline silicon;

f) etching of the silicide where it is not protected by resin;

g) implantation of ionic impurities to definie regions of source (14) and drain (16);

h) removal of the resin;

i) annealing of the substrate.

2. A method according to claim 1, characterized in that before step b) a layer of photosensitive resin (28) is deposited, which is etched to leave it remaining in a zone completely covering the pattern of the gate and overflowing slightly on both sides of the latter, and an implantation of ionic impurities of the opposite kind to that of the substrate is performed.

3. A method according to claim 2, characterized in that after operation h) a layer of photosensitive resin (28) is deposited, which is etched to leave it remaining in a zone completely covering the pattern of the gate and overflowing slightly on both sides of the latter, and an implantation of ionic impurities of the opposite kind to that of the substrate is performed with an energy sufficient for them to pass through the silicide.

**Patentansprüche**

1. Verfahren zur Herstellung einer integrierten Schaltung, das folgende aufeinanderfolgende Schritte umfaßt:

a) Bildung einer die Gateisolierung eines Feldeffekttransistors bildenden dünnen Isolierschicht (20) auf einem Substrat aus monokristallinem Silizium (10) von einem ersten Leitfähigkeitstyp in einer aktiven Zone (A);

b) Ätzen der Isolierschicht (20), um das monokristalline Silizium in den Kontaktzonen zwischen den Source- und Drain-Gebieten und den entsprechenden Elektroden freizulegen;

c) gleichmäßiges Aufbringen einer Siliziummetallverbindung (25) auf dem gesamten Substrat, wobei die Siliziummetallverbindung auf der Gateisolierung dort aufliegt, wo diese vorhanden ist, und auf dem Rest der aktiven Zone in direkten Kontakt mit dem monokristallinen Silizium kommt,

d) Aufbringen einer photoempfindlichen Schicht (32), die geeignet ist, Ätzprodukten der Siliziummetallverbindung standzuhalten und als Maske zu dienen, die die Verunreinigungen bei einer Implantation von Verunreinigungen aufhält,

e) Photogravur der photoempfindlichen Schicht, um ein Harzmuster zu verwirklichen, das einen Harzabschnitt (29) oberhalb der Gateisolierung, welcher Abschnitt dem zu verwirklichenden Gatemuster entspricht, und eine Source-Elektrode, eine Drain-Elektrode und Verbindungen definierende Harzabschnitte (31, 33, 39) enthält, wobei das Harz entlang der Ränder des Gate über der aktiven Zone entfernt wird und über der Siliziummetallverbindung in Abschnitten der aktiven Zone vorhanden bleibt, wo die Siliziummetallverbindung mit dem monokristallinen Silizium in Kontakt ist;

f) Ätzen der Siliziummetallverbindung, wo sie nicht durch das Harz geschützt ist;

g) Ionenimplantation von Verunreinigungen, um die Source- (14) und Drain-Gebiete (16) zu definieren,

h) Entfernen des Harzes,

i) Ausglühen des Substrats.

2. Verfahren nach Anspruch 1, dadurch gekennzeichnet, daß vor dem Schritt b) eine Schicht photoempfindlichen Harzes (28) aufgebracht wird, die so geätzt wird, daß sie in einer das Gatemuster gänzlich bedeckenden Zone bestehen bleibt, wobei sie auf beiden Seiten des Gatemusters geringfügig vorsteht, und daß eine Ionenimplantation von Verunreinigungen jenes Typs durchgeführt wird, der dem des Substrats entgegengesetzt ist.

3. Verfahren nach Anspruch 2, dadurch gekennzeichnet, daß nach dem Schritt h) eine Schicht photosensiblen Harzes (28) aufgebracht wird, die so graviert wird, daß sie in einer das Gatemuster gänzlich bedeckenden Zone bestehen bleibt, wobei sie auf beiden Seiten des Gatemusters geringfügig vorsteht, und daß mit einer zum Durchdringen der Siliziummetallverbindung ausreichenden Energie eine Ionenimplantation von Verunreinigungen jenes Typs durchgeführt wird, der dem des Substrats entgegengesetzt ist.

Fig. 1

Fig. 2

Fig. 3

Fig. 4

Fig. 5

Fig. 6

Fig. 7

Fig. 8